# EUROPEAN PATENT APPLICATION

(11) **EP 4 266 846 A1**
(43) Date of publication of application: **25.10.2023**
(21) Application number: 22275049.9
(22) Date of filing: 21.04.2022
(51) Int. Cl.: H05K 7/20

(54) **BUS BAR FOR DOUBLE-SIDED COLDPLATE**

(71) Applicant: Hamilton Sundstrand Corporation, Charlotte, NC 28217-4578 (US)
(72) Inventor: BENN, Andrew, Kenilworth, CB8 1DA (GB)
(74) Representative: Dehns

(57) **Abstract**

Disclosed herein is a novel bus bar design for use with double-sided cold plates. The bus bar has a rotational symmetry such that the same bus bar can be used, depending on its orientation, to connect on either side of the cold plate. Thus, two identically formed bus bar parts, with one of the parts rotated through 180 degrees relative to the other, can be interconnected to form a bus bar assembly. This can reduce unique part counts.

## Description

### TECHNICAL FIELD

The technology described herein relates to electrical apparatus that include a double-sided cold plate assembly, and in particular to a novel bus bar design for use with the same.

### BACKGROUND

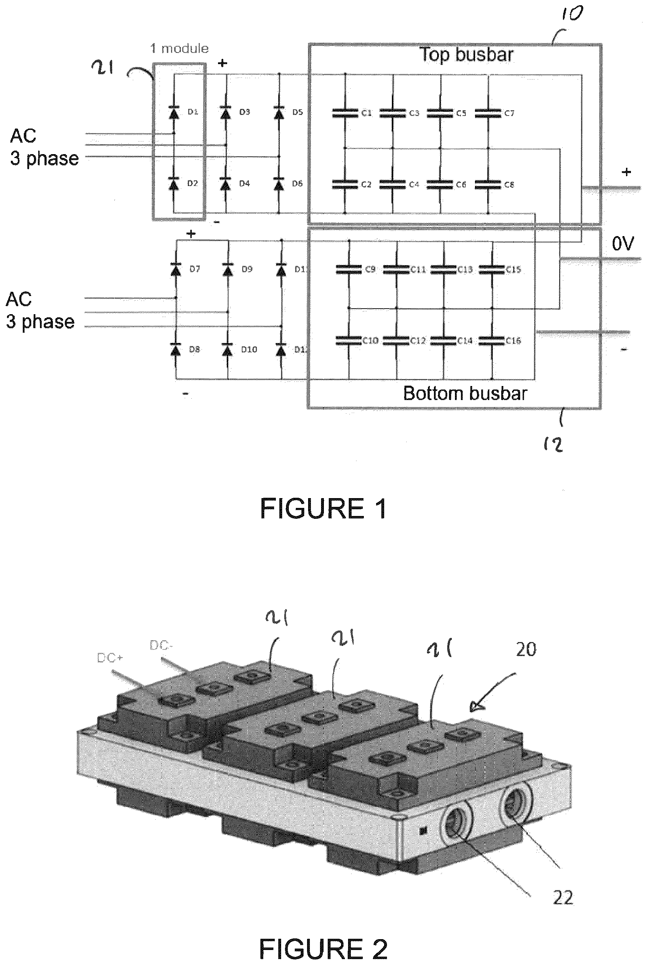

Figure 1 shows an example of a six-phase parallel rectifier circuit including a plurality of power modules (there are six power modules in Figure 1, arranged as respective upper and lower power circuits, each comprising three of the power modules). Each power module is a diode phase leg consisting of two diodes. The power modules are mounted using a double-sided cold plate, as shown in Figure 2, with the power modules symmetrically mounted on either side of the cold plate 20. Thus, as shown in Figure 2, there are a respective three power modules mounted on each side of the cold plate. The cold plate may also, e.g., be referred to, and acts, as a "heat sink".

Referring still to Figure 1, each power circuit is supplied with a respective three-phase AC input, and the outputs of the power modules on either side of the cold plate are then connected in parallel, as shown in Figure 1, with the upper (positive, '+') lines of the power circuits on either side of the cold plate interconnected to provide a first (positive, '+') output, the lower lines of the circuits on either side of the cold plate interconnected to provide a second (negative, '-') output, and the central lines of the circuits on either side of the cold plate interconnected to provide a third (zero) output.

This interconnection is achieved in Figure 1 using a complementary pair of bus bars, with one bus bar (the 'top' bus bar 10) connecting to the three power modules on one side of the cold plate and another bus bar (the 'bottom' bus bar 12) connecting to the three power modules on the other side of the cold plate. The bus bars 10,12 are then interconnected to provide the desired parallel interconnections between the power circuits to provide the three respective output phases as shown on the right hand side of Figure 1.

An example of a bus bar arrangement is disclosed in US 2021/0313900 (Hamilton Sundstrand Corporation).

The Applicants believe however there remains room for improvements to bus bar designs for use for combining power outputs from different sides of a double-sided cold plate assembly.

### SUMMARY

A first aspect of the technology described herein comprises an electrical apparatus comprising:
a double-sided cold plate assembly, the cold plate assembly having a first (upper) side on which is mounted a first electrical circuit comprising a first set of one or more electrical modules and a second (lower) side on which is mounted a second electrical circuit comprising a second set of one or more electrical modules, the respective electrical modules of the first and second electrical circuits being arranged on respective opposing sides of the cold plate assembly; and
a bus bar assembly comprising:
   a first (upper) bus bar connected to the first electrical circuit mounted on the first (upper) side of the cold plate; and
   a second (lower) bus bar connected to the second electrical circuit mounted on the second (lower) side of the cold plate, wherein the second (lower) bus bar is interconnected with the first (upper) bus bar to connect one or more outputs of the first electrical circuit mounted on the first (upper) side of the cold plate to a respective one or more outputs of the second electrical circuit mounted on the second (lower) side of the cold plate to provide a respective parallel output,
   wherein the first (upper) and second (lower) bus bars are identically formed, and have a rotational symmetry such that depending on its orientation the same bus bar can be used either as the first (upper) bus bar or the second (lower) bus bar for the double-sided cold plate assembly.

A second aspect of the technology described herein comprises a bus bar for use with the electrical apparatus described above. The bus bar comprises a first (front) portion for connecting to an electrical circuit mounted on one side of a double-sided cold plate assembly and a second (rear) portion for connecting the bus bar to another, identically formed bus bar. The bus bar is rotationally symmetric such that the same bus bar can be used either as the first (upper) bus bar or the second (lower) bus bar for the double-sided cold plate assembly.

That is, when the bus bar is oriented in a first rotational orientation, the bus bar is configured for use in that orientation as the first (upper) bus bar, that connects to the first (upper) side of the cold plate. However, by rotating the bus bar through 180 degrees into a second rotational orientation, the (same) bus bar is then configured for use as the second (lower) bus bar, that connects to the other (the second, lower) side of the cold plate. When two such identically formed bus bars are provided, when one bus bar is in the first rotational orientation it can accordingly be interconnected with the other bus bar in the second rotational orientation in order to form the bus bar assembly.

That is, in the first rotational orientation, the bus bar is configured to connect to the first electrical circuit that is mounted on the first (upper) side of the cold plate. On the other hand, in the second rotational orientation, the bus bar is configured to connect to the second electrical circuit that is mounted on the second (lower) side of the cold plate. The first and second electrical circuits may, e.g., and in an embodiment are, provided in a symmetric or mirrored arrangement on either side of the cold plate.

The effect of all this is accordingly to provide a reduced part count as the same bus bar design can be used to provide both parts of the bus bar assembly. This can help therefore to simplify manufacturing, e.g. as there is only a need to produce a single type of bus bar part, which can then be used on either side of the cold plate assembly, as required. This also therefore facilitates repair and reduces inventory requirements. Further, this symmetric design in embodiments may facilitate greater overlap between bus bars which can help to provide lower contact resistance and inductance (and thus improved bus bar performance).

The above arrangements may therefore provide various benefits compared to other approaches.

In embodiments, the electrical apparatus is a rectifier, in particular in which each of the electrical modules comprises a power module, e.g. including a diode or switching arm to which a respective phase of an N-phase input is provided, with corresponding phases for the electrical circuits on either side of the cold plate then being connected in parallel using the novel bus bar design. However, other arrangements would of course be possible. Accordingly, the novel bus bar design described above may be used in any suitable electrical apparatus as desired.

There is also provided according to a further aspect a method of manufacturing an electrical apparatus of the type above, that is comprising a double-sided cold plate assembly, the cold plate assembly having a first side on which is mounted a first electrical circuit comprising a first set of one or more electrical modules and a second side on which is mounted a second electrical circuit comprising a second set of one or more electrical modules, the respective electrical modules of the first and second electrical circuits being arranged on either side of the cold plate assembly.

The method comprises providing first and second identically formed bus bars, in particular of the type described above; connecting the first bus bar to the first electrical circuit on the first side of the cold plate assembly, the first bus bar being connected in a first rotational orientation; connecting the second bus bar to the second electrical circuit on the second side of the cold plate assembly, with the second bus bar being connected in a second rotational orientation, wherein the second bus bar is rotated through 180 degrees relative to the first bus bar; and then interconnecting the first and second bus bars to connect one or more outputs of the first electrical circuit mounted on the first side of the cold plate to a respective one or more outputs of the second electrical circuit mounted on the second side of the cold plate to provide a respective parallel output.

It will be appreciated that the method may apply to any electrical apparatus according to any embodiment of the first aspect described herein. Likewise, the bus bars that are used in the method and electrical apparatus may comprise any or all of the features according to embodiments of the second aspect described herein.

### BRIEF DESCRIPTION OF THE DRAWINGS

Various examples will now be described by way of example only and with reference to the drawings, in which:
Figure 1 is a circuit diagram showing an example of an electrical apparatus in which the technology described herein may be used;
Figure 2 shows an example of a double-sided cold plate assembly that may be used with the electrical apparatus of Figure 1; and
Figures 3 to 9 show details of a bus bar arrangement according to an embodiment of the technology described herein.

Like reference numerals are used for corresponding features appearing in multiple figures.

### DETAILED DESCRIPTION

As discussed above, Figure 1 shows an example of an electrical apparatus in particular comprising a six-phase parallel rectifier. In Figure 1, there are therefore six power modules 21, each comprising a diode phase leg consisting of two diodes. The power modules 21 arranged into two respective power circuits, with each power circuit being symmetrically connected on either side of a double-sided cold plate 20 of the type shown in Figure 2. The cold plate 20 is used to cool the power circuits and as shown in Figure 2 comprises an internal fluid circuit 22 within which coolant can circulate in order to transfer heat away from the electrical apparatus. Because electrical apparatus utilizes both sides of the cold plate 20, the usage of available cooling is maximized. This may also provide a more compact design.

Thus, in embodiments, the electrical apparatus comprises a power converter assembly such as a rectifier. In that case, the first electrical circuit of the electrical apparatus may comprise a first set of one or more power modules and the second electrical circuit of the electrical apparatus may comprise a corresponding second set of one or more power modules. The respective sets of power modules may be mounted on either side of the cold plate, e.g. in a symmetric or mirrored arrangement. In embodiments, each set of power modules comprises the same number of (e.g. three, as shown in Figure 1) power modules, with the power modules on each side of the cold plate being arranged in a substantially similar manner. Each power module may, for example, include a diode phase leg. Other arrangements would however be possible. For example, rather than a rectifier including diode phase legs, as shown in Figure 1, the electrical apparatus may comprise parallel switching circuits, e.g. with the diodes in Figure 1 replaced with suitable switching diodes or transistors.

In Figure 1, each of the electrical circuits thus receives a three-phase AC input, with respective phases provided to respective ones of the power modules. The apparatus in Figure 1 thus includes three first AC connectors on the first side of the cold plate and three second AC connectors on the second side of the cold plate. The corresponding phases from the electrical circuits on either side of the cold plate 20 are then interconnected in parallel to provide three respective output phases (positive, zero, negative), as shown on the right hand side in Figure 1.

However, whilst various embodiments will be described in relation to an electrical apparatus in the form of a six-phase rectifier as shown in Figure 1, it will be appreciated that the technology described herein may be used with any suitable and desired electrical apparatus that is mounted using a double-sided cold plate, and wherein a pair of bus bars is therefore needed in order to interconnect power outputs from either side of the cold plate.

For example, in general, each power module may receive a respective phase of an N-phase input, and wherein corresponding phases from power modules from the first and second electrical circuits mounted on different sides of the cold plate assembly are connected in parallel. Thus, in embodiments, the first and second electrical circuits mounted on the cold plate assembly each comprise a respective set of N power modules, where N is one or more.

Further, it will be appreciated that the novel bus bar concept described herein is not limited to use with parallel rectifiers of the type shown in Figure 1, but the concept may also find utility in various other electrical apparatus with other suitable arrangements of electrical circuits that need to be connected in parallel.

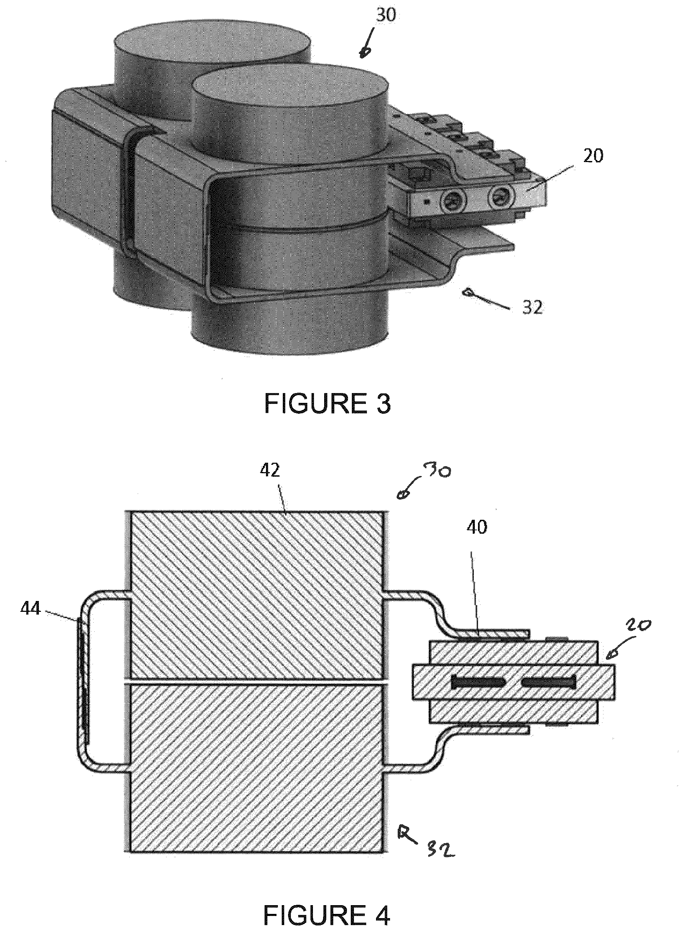

Thus, as will be described further below in relation to Figure 3 to 9, the technology described herein relates particularly to a novel bus bar design concept, which has a rotational symmetry such that the same bus bar design can be used on either side of the cold plate assembly, i.e. by rotating the bus bar appropriately. In this way it is therefore possible to use two identical bus bar parts to interconnect the circuits on either side of the cold plate assembly. In contrast, in conventional arrangements, the bus bar features are not rotationally symmetric, such that two separate bus bar designs, i.e. two separate parts, are needed to interconnect circuits mounted on either side of a double-sided cold plate. This concept can generally be applied to any suitable electrical circuit arrangements, as desired.

The novel bus bar design described herein thus beneficially allows a reduction in the total number of different parts that are required, thus simplifying manufacturing (costs). Further, as will be explained below, the symmetric bus bar design described herein can by design provide very low electrical and magnetic resistance, thus providing an improved bus bar performance.

Figure 3 shows the overall bus bar arrangement including an upper bus bar 30 and lower bus bar 32 that are interconnected to each other at one end (the left hand side in Figure 3) and respectively connected at the other end (the right hand side in Figure 3) to the electrical circuits on either side of a double-sided cold plate assembly 20. Figure 4 is a corresponding cross-sectional view of the connected bus bar arrangement.

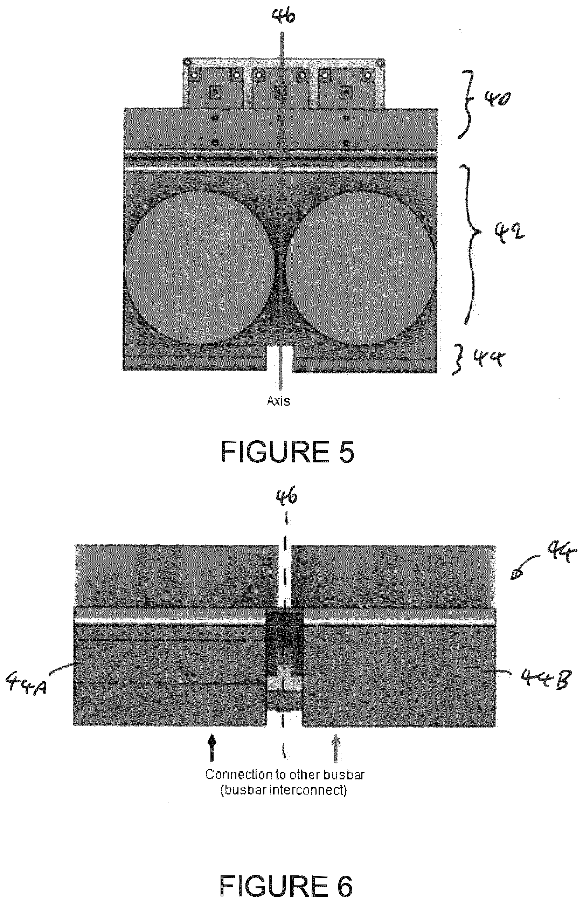

As shown in Figure 4, each bus bar part identically comprises a first portion 40 (or front plate), extending generally parallel to the surface of the cold plate assembly, and configured to connect with the respective electrical modules on one side of the cold plate. This is further illustrated in Figure 5, which shows a top down view of a respective bus bar part. In this example, the first portion 40 (front plate) of each of the bus bar parts thus comprises suitable connections for connecting to the respective three power modules 21 on one side of the cold plate assembly (as best shown in Figure 3). However, it will be appreciated that for other electrical circuit arrangements, the connections on the first portion 40 (front plate) of the bus bar parts may be arranged suitably (and differently), e.g. depending on the number of circuit elements that need to be connected using the bus bar assembly.

Thus, in embodiments, the bus bar (or each of the first and second bus bars) comprises a respective first portion configured to connect the bus bar to a respective one of the electrical circuits mounted on the cold plate, wherein the front portions extend substantially parallel to the surface of the cold plate on which the electrical circuit is mounted.

Each bus bar part further comprises a second portion 44 (or rear plate), extending generally perpendicularly to the surface of the cold plate assembly, that is configured to interconnect with a corresponding second portion 44 (rear plate) of another identical bus bar part that has been rotated through 180 degrees. This is further illustrated in Figure 6 which shows a rear view of a respective bus bar part. As shown in Figure 6, the second portion 44 (rear plate) is split into two halves 44A, 44B about a central axis 46 (the central axis bisecting the second portion 44 as shown in Figure 5 and Figure 6).

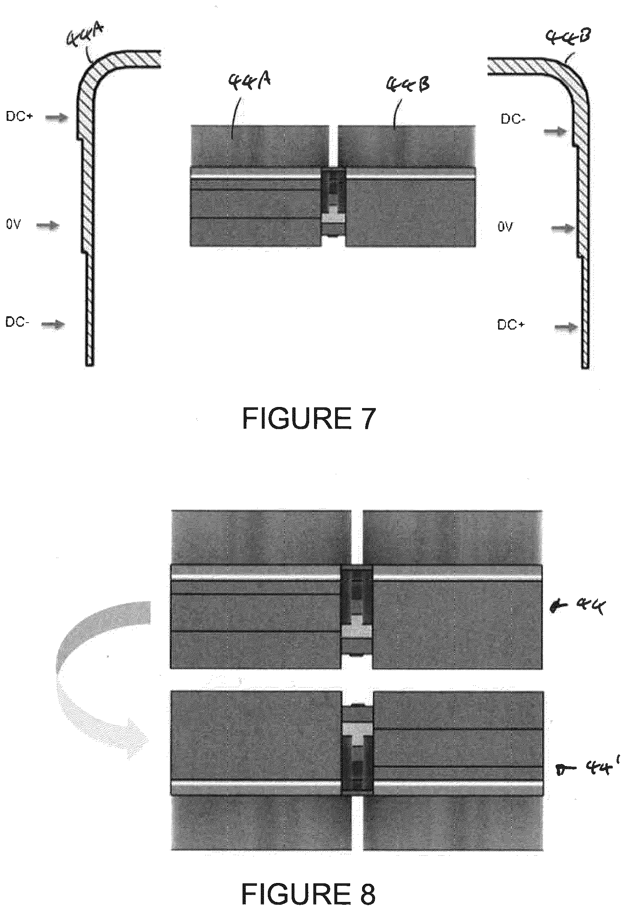

Figure 7 shows in more detail the bus bar interconnects on the second portion 44 of the bus bar. In particular, as shown in side view in Figure 7, each half 44A, 44B of the second portion 44 of the bus bar plate comprises a staggered arrangement of bus bar interconnects, with each connection projected further out by the thickness of one layer of bus bar material. Thus, in embodiments, the (each) bus bar includes a DC positive layer, a DC negative layer and a DC neutral layer.

Further, as shown in Figure 7, the arrangement (order) of the interconnects on each half 44A, 44B is oppositely arranged. Thus, on the left half 44A of the second portion 44, the interconnects may be, and in Figure 7 are, ordered from top to bottom: positive ('+'), zero, negative ('-'), whereas on the right half 44B of the second portion 44, the interconnects are ordered in the opposite direction, i.e.: negative ('-'), zero, positive ('+').

Figure 7 thus shows how the connections can be made in the vertical plane (the plane orthogonal to the surface of the cold plate). In particular, as mentioned above, the order of the connections on each half of the rear portion of the bus bar part are opposite to each other.

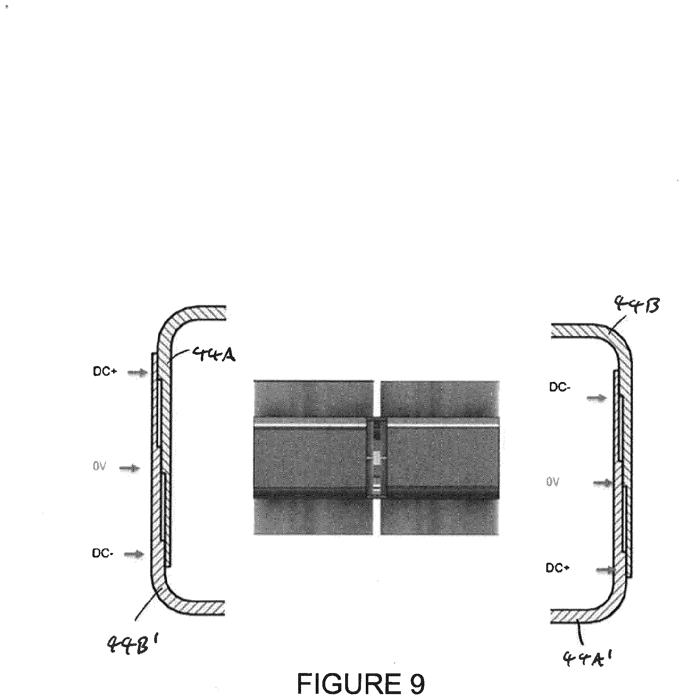

This arrangement means that when two identical such bus bar parts 44, 44' are connected, with one of the bus bar parts 44' being rotated through 180 degrees relative to the other bus bas part 44 (i.e. turned upside down as shown in Figure 8), the respective halves of the respective second portions then interlock with each other in order to interconnect the bus bar parts to define the connected bus bar assembly, with the respective interconnects lining up, as shown in Figure 9.

Figure 9 accordingly shows the side views of how the bus bar parts are interconnected, in particular showing how the connections are made in the vertical plane using the oppositely ordered connections. Thus, as shown in Figure 9, the positive connection on the left half 44A of the rear portion 44 of the upper bus bar 30 interconnects with the right half 44B' of the rear portion 44' of the lower bus bar 32. Correspondingly, the positive connection on the right half 44B of the rear portion 44 of the upper bus bar 30 interconnects with the left half 44A' of the rear portion 44' of the lower bus bar 32. The connections between the zero and negative outputs are made in a similar fashion, as depicted in Figure 9. (Note here that each connection is only made at the position indicated by the arrow. For example, the interconnects generally comprise stripped wires that are only exposed at this point, such that the positive (+) interconnect in one half of the second portion of one bus bar only contacts the corresponding positive (+) interconnect in the other half of the second portion of another rotated bus bar, and so on.)

Thus, in embodiments, the bus bar (or each of the first and second bus bars) comprises a respective second portion, wherein the respective second portions of the first and second bus bars are interconnected to form the bus bar assembly, the second portions extending substantially perpendicular to the surface of the cold plate. The second portion of the (or each) bus bar is in embodiments split into two halves about a central axis of the bus bar, wherein each half comprises a staggered arrangement of electrical connections, with the order of the electrical connections on the two halves of a single bus bar being reversed. Thus, when the bus bar is interconnected with a second, identically formed, bus bar through the respective second portions of the bus bars, with the second bus bar having been rotated through 180 degrees relative to the bus bar such that a first half of the second portion of the bus bar interconnects with a second half of the second portion of the second bus bar and a second half of the second portion of the first bus bar interconnects with a first half of the second portion of the second bus bar, the electrical connections provided on the respective halves of the respective bus bars match with each other to provide the parallel output.

In other words, the arrangement of the bus bars is such that the DC positive layer of the first bus bar assembly can be electrically connected to the DC positive layer of the second bus bar assembly. Likewise, the DC negative layer of the first bus bar assembly can be electrically connected to the DC negative layer of the second bus bar assembly, and the DC neutral layer of the first bus bar assembly can be electrically connected to the DC neutral layer of the second bus bar assembly.

It will be appreciated from Figures 6 to 9 that the bus bar by design may provide a relatively larger contact area for the interconnects as there is a large area of overlap between the respective halves of the rear portions of the interconnected bus bar parts. This in turn helps reduce electrical and magnetic resistance, and improve the bus bar performance. Thus, in addition to reducing part numbers and simplifying manufacture, the bus bar design shown in Figures 3 to 9 also naturally provides an improved high current performance.

Although not shown in the Figures it will be appreciated that additional fixing means may also be provided for connecting the bus bars together. For instance, fixings such as screws may be provided into the second (rear) portions 44, 44' of the bus bars in order to secure them together. Various other arrangements would be possible for joining a pair of bus bars together. In some cases, the interlocking of the respective rear portions 44, 44' may itself provide sufficiently secure attachment.

In addition to the first and second portions 40, 44 described above that serve to connect the bus bars to the electrical circuits and to each other, each bus bar part further comprises a central portion 42 including a capacitor bank, e.g. as illustrated schematically in the circuit diagram in Figure 1, e.g. in order to reduce ripple currents. As shown in Figure 3, for example, these capacitors may be symmetrically arranged about the central axis of the bus bar. This helps ensures a more equal current distribution between the halves of the bus bar.

Thus, in embodiments, the (and each) bus bar comprises a capacitor bank comprising a plurality of capacitors, wherein the capacitors are symmetrically arranged about an axis of the bus bar.

The described embodiments were chosen in order to best explain the principles of the technology described herein and its practical applications, to thereby enable others skilled in the art to best utilise the technology described herein, in various embodiments and with various modifications as are suited to the particular use contemplated. Thus, the foregoing detailed description has been presented for the purposes of illustration and description. It is not intended to be exhaustive or to limit the technology described herein to the precise form disclosed. Many modifications and variations are possible in the light of the above teaching. The scope is defined by the claims appended hereto.

## Claims

1. An electrical apparatus comprising:
a double-sided cold plate assembly, the cold plate assembly having a first side on which is mounted a first electrical circuit comprising a first set of one or more electrical modules and a second side on which is mounted a second electrical circuit comprising a second set of one or more electrical modules, the respective electrical modules of the first and second electrical circuits being arranged on respective opposing sides of the cold plate assembly; and
a bus bar assembly comprising:
a first bus bar connected to the first electrical circuit mounted on the first side of the cold plate; and
a second bus bar connected to the second electrical circuit mounted on the second side of the cold plate, wherein the second bus bar is interconnected with the first bus bar to connect one or more outputs of the first electrical circuit mounted on the first side of the cold plate to a respective one or more outputs of the second electrical circuit mounted on the second side of the cold plate to provide a respective parallel output,
wherein the first and second bus bars are identically formed, and have a rotational symmetry such that depending on its orientation the same bus bar can be used either as the first bus bar or the second bus bar for the double-sided cold plate assembly.

2. The electrical apparatus of claim 1, wherein the first and second bus bars each comprise a respective first portion configured to connect the bus bar to a respective one of the electrical circuits mounted on the cold plate, wherein the front portions extend substantially parallel to the surface of the cold plate on which the electrical circuit is mounted, wherein the first and second bus bars each further comprise a respective second portion, wherein the respective second portions of the first and second bus bars are interconnected to form the bus bar assembly.

3. The electrical apparatus of claim 2, the second portions extending substantially perpendicular to the surface of the cold plate.

4. The electrical apparatus of claim 2 or s3, wherein the second portion of each of the first and second bus bars is split into two halves about a central axis of the bus bar, wherein each half comprises a staggered arrangement of electrical connections, with the order of the electrical connections on the two halves of a single bus bar being reversed so that when the first and second bus bars are interconnected through their second portions, with the second bus bar having been rotated through 180 degrees relative to the first bus bar such that a first half of the second portion of the first bus bar interconnects with a second half of the second portion of the second bus bar and a second half of the second portion of the first bus bar interconnects with a first half of the second portion of the second bus bar, the electrical connections provided on the respective halves of the respective bus bars match with each other to provide the parallel output.

5. The electrical apparatus of any preceding claim, wherein each of the first and second bus bars further comprise a capacitor bank comprising a plurality of capacitors, wherein the capacitors are symmetrically arranged about an axis of the bus bar.

6. The electrical apparatus of any preceding claim, wherein the first and second electrical circuits mounted on the cold plate assembly each comprise a respective set of N power modules, where N is one or more.

7. The electrical apparatus of claim 6, wherein each power module receives a respective phase of an N-phase input, and wherein corresponding phases from power modules from the first and second electrical circuits mounted on different sides of the cold plate assembly are connected in parallel.

8. The electrical apparatus of claim 7, wherein each power module comprises a diode or switching arm.

9. The electrical apparatus of any preceding claim, being a rectifier.

10. A bus bar, in particular for use with the electrical apparatus of claim 1, wherein the bus bar comprises a first portion for connecting to an electrical circuit mounted on one side of a double-sided cold plate assembly and a second portion for connecting the bus bar to another, identically formed bus bar, wherein the bus bar is rotationally symmetric such that the same bus bar can be used on either side of the double-sided cold plate assembly.

11. The bus bar of claim 10, wherein the first portion extends substantially parallel to the surface of the cold plate on which the electrical circuit is mounted.

12. The bur bar of claim 10 or 11, wherein the second portion extends substantially perpendicular to the surface of the cold plate.

13. The bus bar of any of claims 10, 11 or 12, wherein the second portion is split into two halves about a central axis of the bus bar, wherein each half comprises a staggered arrangement of electrical connections, with the order of the electrical connections on the two halves of the bus bar being reversed.

14. The bus bar of any of claims 10 to 13, comprising a capacitor bank comprising a plurality of capacitors, wherein the capacitors are symmetrically arranged about an axis of the bus bar.

15. A method of manufacturing an electrical apparatus comprising a double-sided cold plate assembly, the cold plate assembly having a first side on which is mounted a first electrical circuit comprising a first set of one or more electrical modules and a second side on which is mounted a second electrical circuit comprising a second set of one or more electrical modules, the respective electrical modules of the first and second electrical circuits being arranged on either side of the cold plate assembly, the method comprising:
providing first and second identically formed bus bars, in particular of the type claimed in any of claims 10 to 14;
connecting the first bus bar to the first electrical circuit on the first side of the cold plate assembly, the first bus bar being connected in a first rotational orientation;
connecting the second bus bar to the second electrical circuit on the second side of the cold plate assembly, with the second bus bar being connected in a second rotational orientation, wherein the second bus bar is rotated through 180 degrees relative to the first bus bar; and
interconnecting the first and second bus bars to connect one or more outputs of the first electrical circuit mounted on the first side of the cold plate to a respective one or more outputs of the second electrical circuit mounted on the second side of the cold plate to provide a respective parallel output.
